Europäisches Patentamt

European Patent Office

Office européen des brevets

(11) Veröffentlichungsnummer: **0 320 738**

**A2**

(12) # EUROPÄISCHE PATENTANMELDUNG

(21) Anmeldenummer: 88120263.4

(22) Anmeldetag: 05.12.88

(51) Int. Cl.4: **H01L 29/743 , H01L 29/06 , H01L 29/91 , H03K 17/73 , H03K 17/06**

(30) Priorität: 17.12.87 DE 3742895

(43) Veröffentlichungstag der Anmeldung: 21.06.89 Patentblatt 89/25

(84) Benannte Vertragsstaaten: AT CH DE FR GB IT LI SE

(71) Anmelder: **Siemens Aktiengesellschaft Berlin und München**
**Wittelsbacherplatz 2**
**D-8000 München 2(DE)**

(72) Erfinder: **Voss, Peter, Dr. Ing.**
**Rudliebstrasse 42**
**D-8000 München 81(DE)**

(54) Überkopfzündfester Thyristor.

(57) Thyristoren können beim Überkopfzünden zerstört werden. Die Erfindung sieht deshalb vor, einen überkopfzündfesten Thyristor zu bilden. Der erfindungsgemäße überkopfzündfeste Thyristor weist einen Bereich (2) auf, der im Vergleich zum übrigen Halbleiterkörper eine geringere Durchbruchsspannung hat. Dieser Bereich (2) ist mit einer Hilfselektrode (11) versehen und ist vom übrigen Halbleiterkörper (1) durch einen Graben (12) so getrennt, daß sich beim Einsatz des Lawinendurchbruchs in Blockierrichtung eine Spannung größer 0,5 V gegenüber der ersten Emitterelektrode (8) aufbauen kann, ohne daß der Thyristor zündet. Die Hilfselektrode (11) ist über einen Widerstand (13) mit der ersten Emitterelektrode (8) des Thyristors verbunden. Außerdem ist zwischen der Hilfselektrode (11) und der Steuerelektrode (10) ein Kippelement geschaltet, das bei einem vorbestimmten Spannungsabfall am Widerstand (13) durchschaltet und den Zündvorgang des Thyristors einleitet.

FIG 1

# Überkopfzündfester Thyristor

Die Erfindung betrifft einen überkopfzündfesten Thyristor, wie er in dem Oberbegriff des Anspruchs 1 beschrieben ist.

Es ist bekannt, daß ein Thyristor auch ohne einen an die Steuerelektrode angelegten Steuerimpuls zündet, wenn die Anoden-Katoden-Spannung größer als die für den jeweiligen Thyristor typische Nullkippspannung ist. Dies wird als "Überkopfzünden" bezeichnet. Das Überkopfzünden sollte für die herkömmlichen Thyristoren vermieden werden, da bei diesem Zündvorgang der Thyristor den ungünstigsten Einschaltbedingungen ausgesetzt ist. So zündet der Thyristor zuerst nur punktförmig. Dieser punktförmige Bereich muß den gesamten Laststrom solange übernehmen, bis sich der Zündvorgang ausgehend von diesem punktförmigen Bereich ausgebreitet hat. Dies führt im allgemeinen zum lokalen Überhitzen und zur möglichen Zerstörung des Thyristors.

Es sind überkopfzündfeste Thyristoren bekannt, mit denen ein gefahrloses Überkopfzünden möglich ist. Diese Thyristoren weisen einen Bereich auf, der gegenüber dem übrigen Halbleiterkörper eine niedrigere Durchbruchsspannung hat. Bei Spannungsüberlastung gelangt dieser Bereich zuerst in den Durchbruch.

Nachteilig bei diesen bekannten überkopfzündfesten Thyristoren ist, daß der Einschaltbereich selbst dann noch stark gefährdet ist, wenn der Bereich niedrigerer Durchbruchsspannung innerhalb eines Hilfsthyristors liegt. Der Grund liegt darin, daß der Einschaltbereich häufig sehr klein ist und die Entlastung durch den Hauptthyristor nicht schnell genug erfolgen kann.

Ein überkopfzündfester Thyristor ist z. B. in der DE-OS 23 00 754 beschrieben. Die FIG 1 dieser Veröffentlichung zeigt einen einen Thyristor bildenden Halbleiterkörper, der einen Hauptthyristorbereich und einen Hilfsthyristorbereich aufweist. Der Hauptthyristorbereich ist ringförmig um den Hilfsthyristorbereich angeordnet, der wiederum ringförmig ausgebildet ist. Innerhalb des Hilfsthyristorbereiches ist der Bereich niedrigerer Durchbruchsspannung angeordnet. Dieser Bereich besteht aus der ersten Basiszone, der zweiten Basiszone und der zweiten Emitterzone des Halbleiterkörpers und hat eine niedrigere Durchbruchsspannung als der übrige Halbleiterkörper. Die erste Basiszone ist in diesem Bereich mit einer Hilfselektrode verbunden, die über einen Widerstand an die erste Emitterelektrode des Hauptthyristors angeschlossen ist. Der Hilfsthyristorbereich weist außerdem eine getrennte Steuerelektrode für das konventionelle Zünden mit Steuerstrom auf. Beim Überkopfzünden fließt der Lawinenstrom zuerst zur Hilfselektrode und über den Widerstand zur ersten Emitterelektrode des Hauptthyristors ab. Ein Teil des Stromes fließt bei der in FIG 1 der DE-OS 23 00 754 gezeigten Thyristoranordnung (vgl. dazu linker Pfeil in FIG 1) in der ersten Basiszone unter der Emitterzone des Hilfsthyristors zur ersten Emitterelektrode des Hauptthyristors. Bei genügend hohem Strom zündet der Hilfsthyristor, der seinerseits den Hauptthyristor soviel Strom zuführt, daß dieser linienförmig zünden kann und eine Zerstörung durch Überkopfzünden vermieden wird.

Diese bekannte Anordnung hat jedoch den Nachteil, daß je nach Größe des Widerstandes der auslösende Überkopfzündstrom größer sein kann als der normale Zündstrom des Hilfsthyristorbereiches, wenn mit Steuerstrom an der Steuerelektrode gezündet wird. Auf diese Weise kann der Bereich niedrigerer Durchbruchsspannung auch eine Spannungsbegrenzerfunktion übernehmen, ohne den Thyristor unbedingt zu zünden.

Unserer Erfindung liegt die Aufgabe zugrunde, einen überkopfzündfesten Thyristor anzugeben, bei dem auch bei geringem du/dt ein im Vergleich zum minimalen Auslösestrom hoher Überkopfzündstrom an die Steuerelektrode des Thyristors gelangt und dadurch ein großflächiges Einschalten erreicht wird.

Diese Aufgabe wird durch die kennzeichnenden Merkmale des Anspruches 1 gelöst.

Weiterbildungen der Erfindung sind Gegenstand der Unteransprüche.

Die Erfindung wird im Folgenden anhand von 3 Figuren näher erläutert. Es zeigen:

FIG 1 den Schnitt durch ein erstes erfindungsgemäßes Ausführungsbeispiel, bei dem der Bereich niedrigerer Durchbruchsspannung etwa zentral im Halbleiterkörper angeordnet ist,

FIG 2 die Aufsicht auf einen Thyristor mit einem Halbleiterkörper nach FIG 1, bei dem der Widerstand in den Halbleiterkörper integriert ist, und

FIG 3 ein zweites erfindungsgemäßes Ausführungsbeispiel, bei dem der Sollbruchbereich am Rand des Halbleiterkörpers angeordnet ist.

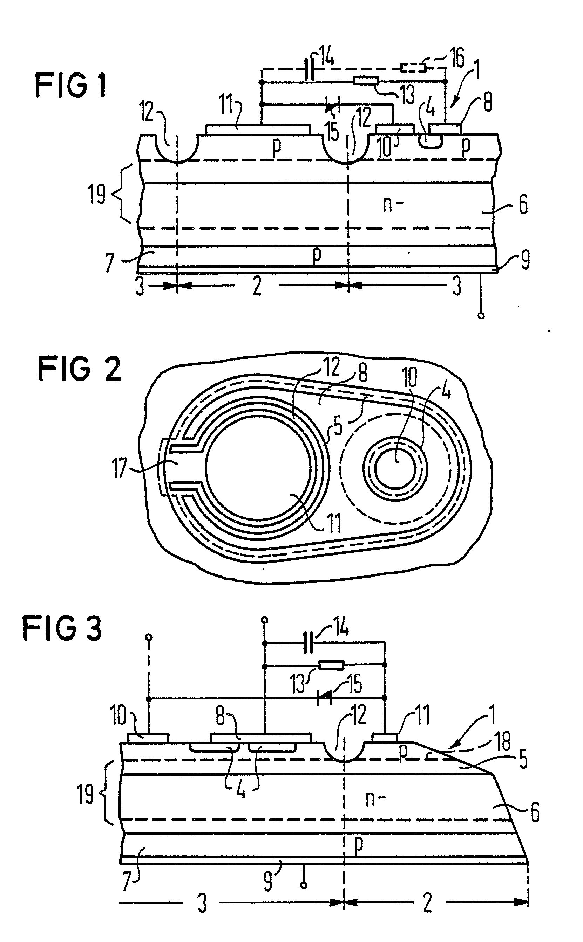

Der in FIG 1 dargestellte und lediglich als Ausführungsbeispiel zu wertende Thyristor hat einen Halbleiterkörper 1, der einen ersten Bereich 3 und einen zweiten Bereich 2, der eine niedrigere Durchbruchsspannung als der erste Bereich 3 aufweist. Dieser zweite Bereich 2 ist z. B. zentral im Inneren des Halbleiterkörpers 1 angeordnet und wird vom ersten Bereich 3 beispielsweise ringförmig umgeben. Dieser erste Bereich 3 entspricht dem Aufbau bzw. der Schichtstruktur eines herkömmlichen Thyristors. Der Bereich 3 weist mindestens teilweise vier übereinanderliegende Zonen jeweils entgegengesetzten Leitfähigkeitstyps auf, von der die beiden äußeren Zonen die erste Emitterzone 4 und die zweite Emitterzone 7 bilden, während die beiden inneren Zonen die erste Basiszone 5 und die zweite Basiszone 6 sind. In der Darstellung nach FIG 1 ist angenommen, daß die erste Emitterzone 4 n-dotiert, die erste Basiszone p-dotiert, die zweite Basis- zone 6 schwach n-dotiert und die zweite Emitterzone 7 p-dotiert ist. Die an die erste Emitterzone 4 grenzende erste Basiszone 5 ist mit einer Steuerelektrode 10 verbunden. Diese Steuerelektrode 10 kann auch die Steuerelektrode eines zur Zündverstärkung in den Thyristor integrierten Hilfsthyristors sein. Die Emitterzone 4 steht mit einer ersten Emitterelektrode 8 und die zweite Emitterzone 7 mit einer zweiten Emitterelektrode 9 in Kontakt 9. Die erste Emitterzone 4 weist mindestens einen Nebenschluß auf, der z. B. - wie in FIG 1 dargestellt - dadurch realisiert ist, daß die erste Emitterelektrode 8 die erste Emitterzone 4 überlappt bzw. dadurch, daß die erste Emitterzone 4 Kurzschlußlöcher aufweist. Der zweite Bereich 2 weist eine Dreischichtstruktur, z. B. eine pnp-Struktur auf. Die erste Basiszone 5 ist im zweiten Bereich 2 mit einer Hilfselektrode 11 elektrisch verbunden. In diesem Ausführungsbeispiel ist der zweite Bereich 2 niedrigerer Durchbruchsspannung vom ersten Bereich 3 durch einen Graben 12 getrennt. Dieser Graben 12 ist mindestens so tief, daß er mindestens die Raumladungszone berührt, wenn der Lawinendurchbruch in Blockierrichtung einsetzt. Dieser Graben ist also so tief, daß er im Durchbruchsfall die sich am pn-Übergang zwischen den beiden Basiszonen 5 und 6 ausbildende Raumladungszonen 19 berührt. Dadurch wird erreicht, daß im Durchbruchsfall die Hilfselektrode 11 von der ersten Emitterelektrode 8, der zweiten Emitterelektrode 9 sowie der Steuerelektrode 10 elektrisch isoliert ist.

Zwischen der Hilfselektrode 11 und der ersten Emitterelektrode 8 ist ein Widerstand 13 geschaltet. Zusätzlich ist zwischen der Hilfselektrode 11 und der Steuerelektrode 10 ein Kippelement 15, z. B. eine Break-Over-Diode (BOD), geschaltet. Dieses Kippelement schaltet bei einem vorbestimmten Spannungsabfall am Widerstand 13 durch. Dadurch wird der Steuerelektrode 10 des Thyristors ein Steuerstrom zugeführt und der Zündvorgang des Thyristors eingeleitet. Die Kippspannung des Kippelementes 15 kann zwischen 0,5 V und mehreren 100 V liegen, je nachdem, wie stark sich die Durchbruchsspannung des zweiten Bereiches 2 und die des ersten Bereiches 3 voneinander unterscheiden und welche Durchbruchsströme zugelassen werden.

Die Wirkungsweise dieser Anordnung stellt sich so dar: Wird angenommen, daß beim Lawinendurchbruch ein Strom von z. B. 1 A fließt und der Widerstand 13 einen Wert von 100 Ohm hat, so fällt am Widerstand 13 eine Spannung von 100 V ab. Weist das Kippelement 15 eine Kippspannung von 100 V auf, so schaltet das Kippelement 15 1 A auf die Steuerelektrode 10 des Thyristors. Wird diesem Widerstand 13 zusätzlich ein Kondensator 14, mit z. B. 10 nF, parallel geschaltet, so wird vor dem Kippvorgang des Kippelementes 15 eine Ladung von 1 μAs gespeichert, die beim Zünden zu einem erhöhten Zündstrom führt. Der Zündvorgang wird dadurch weiter verbessert. In diesem Ausführungsbeispiel ist dem Kondensator 14 ein Widerstand 16 in Reihe geschaltet. Er dient zur Schwingungsdämpfung beim Einschalten des Kippelementes 15.

In FIG 2 ist die Aufsicht auf die in FIG 1 dargestellten Halbleiterkörper 1 gezeigt. Funktionsgleiche Teile wie in FIG 1 sind mit denselben Bezugszeichen versehen. Der Bereich 2 hat maximal den Durchmesser des ringförmigen Grabens 12. Der in FIG 1 dargestellte Widerstand 13 ist in den Halbleiterkörper 1 integriert, und besteht aus einer p-leitenden Schicht, die sich in einer Aussparung des Grabens 12 befindet. Diese p-leitende Schicht ist in FIG 2 mit 17 bezeichnet. Auch das Kippelement 15 ist, z. B. als lateraler Thyristor, in den Halbleiterkörper 1 integrierbar.

In FIG 3 ist ein weiteres Ausführungsbeispiel für einen Thyristor mit einem Halbleiter 1 und einer Beschaltung gemäß der Erfindung dargestellt. Auch hier sind funktionsgleiche Teile mit dem bereits bekannten Bezugszeichen versehen. Im Unterschied zur in FIG 2 dargestellten Anordnung ist der zweite Bereich 2 niedrigerer Durchbruchsspannung jetzt am Rand 18 des Halbleiterkörpers 1 angeordnet. Dieser Bereich 2 hat auch hier eine geringere Durchbruchsspannung als der übrige erste Bereich 3 des Halbleiterkörpers 1. Diese geringe Durchbruchsspannung entsteht hier dadurch, daß der Rand des Halbleiterkörpers für die Blokkierrichtung mit einem negativen Winkel versehen ist.

## Ansprüche

1. Überkopfzündfester Thyristor mit einem Halbleiterkörper (1), der folgende Merkmale aufweist:

a) eine Dreischichtstruktur und mindestens teilweise vier aufeinanderfolgende Zonen entgegengesetzten Leitfähigkeitstyps, von denen die beiden äußeren Zonen die Emitterzonen (4, 7) und die beiden inneren Zonen die Basiszonen (5, 6) sind;

b) einen ersten Bereich und einen zweiten Bereich, der eine niedrigere Durchbruchsspannung als der erste Bereich aufweist;

c) die vier aufeinanderfolgenden Zonen (4, 5, 6, 7) liegen mindestens teilweise im ersten Bereich, wobei die erste Emitterzone (4) mit einer ersten Emitterelektrode (8), die zweite Emitterzone (7) mit einer zweiten Emitterelektrode (9) und die an die erste Emitterzone (4) grenzende erste Basiszone (5) mit einer Steuerelektrode (10) verbunden ist;

d) die erste Emitterzone (4) weist mindestens einen Nebenschluß auf;

e) die erste Basiszone (5) ist im zweiten Bereich (2) mit einer Hilfselektrode (11) verbunden;

f) zwischen der ersten Emitterelektrode (8) und der Hilfselektrode (11) ist ein Widerstand (13) geschaltet;

**gekennzeichnet** durch folgende Merkmale:

g) der zweite Bereich (2) ist vom ersten Bereich (3) durch einen Graben (12) getrennt, der so tief ist, daß er mindestens die sich zwischen den beiden Basiszonen (5 und 6) ausbildende Raumladungszone (19) berührt, wenn der Lawinendurchbruch in Blockierrichtung einsetzt;

h) zwischen Hilfselektrode (11) und Steuerelektrode (10) ist ein Kippelement (15) geschaltet, das bei einem vorbestimmten Spannungsabfall am Widerstand (13) durchschaltet und den Zündvorgang des Thyristors einleitet.

2. Thyristor nach Anspruch 1, **dadurch gekennzeichnet,** daß dem Widerstand (13) ein Kondensator (14) parallel geschaltet ist.

3. Thyristor nach Anspruch 1, **dadurch gekennzeichnet,** daß dem Widerstand (13) die Serienschaltung eines Kondensators (14) mit Widerstand (16) parallel geschaltet ist.

4. Thyristor nach einem der Ansprüche 1 bis 3, **dadurch gekennzeichnet,** daß das Kippelement (15) eine Diode ist

5. Thyristor nach einem der Ansprüche 1 bis 3, **dadurch gekennzeichnet,** daß das Kippelement (15) ein Thyristor ist.

6. Thyristor nach einem der Ansprüche 1 bis 5, **dadurch gekennzeichnet,** daß der Widerstand (13) in den Halbleiterkörper (1) integriert ist.

7. Thyristor nach einem der Ansprüche 1 bis 6, **dadurch gekennzeichnet,** daß der erste Bereich (3) den zweiten Bereich (2) ringförmig umgibt.

8. Thyristor nach einem der Ansprüche 1 bis 6, **dadurch gekennzeichnet,** daß der zweite Bereich (2) am Rand (18) des Halbleiterkörpers (1) angeordnet ist.

FIG 1

FIG 2

FIG 3